# EUROPEAN PATENT APPLICATION

(11) **EP 4 541 846 A1**
(43) Date of publication of application: **23.04.2025**
(21) Application number: 23872691.3
(22) Date of filing: 24.05.2023
(51) Int. Cl.: C08K 5/11, C08K 5/14, C08L 23/08, H01L 31/048

(54) **ENCAPSULANT FILM COMPOSITION, AND ENCAPSULANT FILM COMPRISING SAME**

(30) Priority: 30.09.2022 KR 20220125138
(71) Applicant: LG Chem, Ltd., Yeongdeungpo-gu Seoul 07336 (KR)
(72) Inventor: PARK, Sang Eun, Daejeon 34122 (KR); LEE, Jin Kuk, Daejeon 34122 (KR); KIM, Jong Gil, Daejeon 34122 (KR); LEE, Eun Jung, Daejeon 34122 (KR)
(74) Representative: Hoffmann Eitle
(86) International application number: PCT/KR2023/007057
(87) International publication number: WO 2024/071561

(57) **Abstract**

The present invention relates to a composition for an encapsulant film, comprising an ethylene/alpha-olefin copolymer, an encapsulant film and a solar cell module.

## Description

### TECHNICAL FIELD

### Cross-reference to Related Applications

This application claims the benefit of Korean Patent Application No. 2022-0125138, filed on September 30, 2022, in the Korean Intellectual Property Office, the contents of which are incorporated herein by reference.

### Technical Field

The present invention relates to a composition for an encapsulant film, comprising an ethylene/alpha-olefin copolymer, an encapsulant film and a solar cell module.

### BACKGROUND ART

As global environmental problems, energy problems, etc. get worse and worse, solar cells receive attention as an energy generating means without fear of environmental contamination and exhaustion. If solar cells are used outside such as the roof of a building, generally, a module type of the solar cells is used. In order to obtain a crystalline solar cell module when manufacturing a solar cell module, front glass/solar cell encapsulant/crystalline solar cell device/solar cell encapsulant/rear glass (or rear protection sheet) are laminated in order. As the encapsulant of the solar cells, generally, an ethylene/vinyl acetate copolymer or ethylene/alpha-olefin copolymer, having excellent transparency, flexibility, adhesiveness, etc. is used.

A solar cell module is obtained by protecting a solar cell device of silicon, gallium-arsenic, copper-indium-selenium, or the like using an upper transparent protecting material and a lower substrate protecting material, and packaging by fixing the solar cell device and the protecting materials using a sealant. Generally, the sealant of the solar cell device in a solar cell module is formed by extrusion molding of an ethylene/alpha-olefin copolymer mixed with an organic peroxide or a silane coupling agent into a sheet type, and the solar cell device is sealed by using the sheet type sealant to manufacture a solar cell module.

In case of manufacturing the above-described solar cell module, the increase of the affinity of an ethylene/alpha-olefin copolymer with various materials included in a composition for an encapsulant film to improve absorbency may be a way of increasing productivity. Particularly, a crosslinking agent, a crosslinking auxiliary agent, or the like, essentially required to use for the manufacture of an encapsulant film, are polar materials and have low absorbency with respect to a non-polar ethylene/alpha-olefin copolymer and thus, are pointed to as one of the factors inducing productivity deterioration.

### [Prior Art Document]

### [Patent Document]

(Patent Document 1) Japanese Laid-open Patent No. 2015-211189

### DISCLOSURE OF THE INVENTION

### TECHNICAL PROBLEM

An object of the present invention is to reduce the immersion time of an ethylene/alpha-olefin copolymer at an initiation step when manufacturing an encapsulant film by using a crosslinking agent, a crosslinking auxiliary agent, or the like, having high affinity with the ethylene/alpha-olefin copolymer.

### TECHNICAL SOLUTION

To solve the above tasks, the present invention provides a composition for an encapsulant film, an encapsulant film, and a solar cell module.
(1) The present invention provides a composition for an encapsulant film, comprising an ethylene/alpha-olefin copolymer, an organic peroxide crosslinking agent, a crosslinking auxiliary agent and a silane coupling agent, wherein the crosslinking auxiliary agent comprises a compound represented by Formula 1.

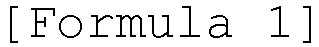

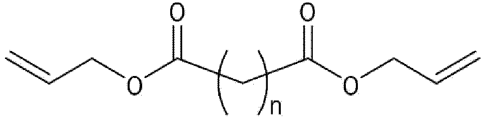

   n is an integer of 1 to 20.
(2) The present invention provides the composition for an encapsulant film according to (1), wherein, in Formula 1, n is an integer of 3 to 10.
(3) The present invention provides the composition for an encapsulant film according to (1) or (2), wherein the compound represented by Formula 1 is a compound below. 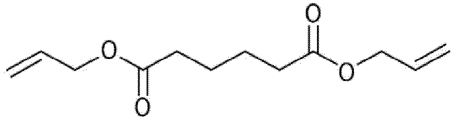
(4) The present invention provides the composition for an encapsulant film according to any one among (1) to (3), wherein the crosslinking auxiliary agent is 0.01 to 3 parts by weight based on 100 parts by weight of the composition for an encapsulant film.
(5) The present invention provides the composition for an encapsulant film according to any one among (1) to (4), wherein the crosslinking auxiliary agent further comprises an allyl-containing compound.
(6) The present invention provides the composition for an encapsulant film according to (5), wherein the allyl-containing compound comprises one or more selected from the group consisting of triallyl isocyanurate, triallyl cyanurate, diallyl phthalate, diallyl fumarate and diallyl maleate.
(7) The present invention provides the composition for an encapsulant film according to (5) or (6), wherein the allyl-containing compound is comprised in 0.01 to 3 parts by weight based on 100 parts by weight of the composition for an encapsulant film.
(8) The present invention provides the composition for an encapsulant film according to any one among (5) to (7), wherein a molar ratio of the compound represented by Formula 1 to the allyl-containing compound is 1: 0.1 to 1: 10.
(9) The present invention provides the composition for an encapsulant film according to any one among (1) to (8), wherein the organic peroxide crosslinking agent is one or more selected from the group consisting of t-butylperoxy 2-ethylhexyl carbonate, t-amylperoxy 2-ethylhexyl carbonate, 1,1-di(t-butylperoxy)-3,3,5-trimethylcyclohexane, 1,1-di(t-butylperoxy)-cyclohexane, 2,2-di(t-amylperoxy)-butane, 2,2-di(t-butylperoxy)-butane, n-butyl-4,4-di(t-butylperoxy)valate, polyether poly(t-butyl peroxycarbonate), t-amylperoxy 3,5,5-trimethylhexanoate, t-butyl peroxyacetate and t-butyl peroxybenzoate.
(10) The present invention provides the composition for an encapsulant film according to any one among (1) to (9), wherein an alpha-olefin comprises one or more selected from the group consisting of propylene, 1-butene, 1-pentene, 4-methyl-1-pentene, 1-hexene, 1-heptene, 1-octene, 1-decene, 1-undecene, 1-dodecene, 1-tetradecene, 1-hexadecene and 1-eicosene.
(11) The present invention provides an encapsulant film comprising the composition for an encapsulant film according to any one of (1) to (10).
(12) The present invention provides a solar cell module comprising the encapsulant film of (11).

### ADVANTAGEOUS EFFECTS

When manufacturing an encapsulant film using the composition for an encapsulant film according to the present invention, the immersion time of an ethylene/alpha-olefin copolymer may be reduced, and the economic feasibility of the production process of the encapsulant film may be improved. In addition, the composition for an encapsulant film prepared by using the present invention shows excellent degree of crosslinking.

### BEST MODE FOR CARRYING OUT THE INVENTION

Hereinafter, the present invention will be described in more detail to assist the understanding of the present invention.

It will be understood that words or terms used in the present disclosure and claims shall not be interpreted as the meaning defined in commonly used dictionaries. It will be further understood that the words or terms should be interpreted as having a meaning that is consistent with their meaning in the context of the relevant art and the technical idea of the invention, based on the principle that an inventor may properly define the meaning of the words or terms to best explain the invention.

### <Composition for encapsulant film>

The composition for an encapsulant film of the present invention is characterized in comprising an ethylene/alpha-olefin copolymer, an organic peroxide crosslinking agent, a crosslinking auxiliary agent and a silane coupling agent, wherein the crosslinking auxiliary agent comprises a compound represented by Formula 1.

### Ethylene/Alpha-olefin Copolymer

The composition for an encapsulant film of the present invention includes an ethylene/alpha-olefin copolymer. The ethylene/alpha-olefin copolymer is prepared by copolymerizing ethylene and an alpha-olefin-based monomer, and in this case, an alpha-olefin which means a moiety derived from an alpha-olefin-based monomer in the copolymer may be an alpha-olefin of 4 to 20 carbon atoms, particularly, propylene, 1-butene, 1-pentene, 4-methyl-1-pentene, 1-hexene, 1-heptene, 1-octene, 1-decene, 1-undecene, 1-dodecene, 1-tetradecene, 1-hexadecene, 1-eicosene, etc., and any one among them or mixtures of two or more thereof may be used.

Among them, the alpha-olefin may be 1-butene, 1-hexene or 1-octene, preferably, 1-butene, 1-octene, or the combination thereof.

In addition, in the ethylene/alpha-olefin copolymer, the alpha-olefin content may be suitably selected in the range satisfying the physical conditions, particularly, greater than 0 to 99 mol%, or 10 to 50 mol%, without limitation.

In the present invention, a preparation method or an obtaining route of the ethylene/alpha-olefin copolymer is not limited, and suitable ones may be selected and used considering the physical properties and purpose of the composition for an encapsulant film by a person skilled in the art.

### Organic Peroxide Crosslinking Agent

The composition for an encapsulant film of the present invention includes an organic peroxide crosslinking agent. The organic peroxide crosslinking agent is a radical initiator in the preparation step of a silane modified resin composition, and may play the role of initiating the graft reaction of an unsaturated silane compound onto a resin composition. In addition, by forming a crosslinking bond among the silane modified resin composition, or between the silane modified resin composition and unmodified resin composition during a lamination step for manufacturing an optoelectronic device, the heat resistant durability of a final product, for example, an encapsulant sheet may be improved.

Particularly, an encapsulant for a solar cell may include an organic peroxide as a crosslinking agent, and the organic peroxide plays the role of improving the weather resistance of the encapsulant for a solar cell.

The organic peroxide crosslinking agent may have a one-hour half-life temperature of 115 to 130°C.

The "one-hour half-life temperature" means a temperature at which the half-life of the crosslinking agent becomes one hour. According to the one-hour half-life temperature, the temperature at which a radical initiation reaction is efficiently performed may become different. Therefore, in case of using the organic peroxide crosslinking agent having the one-hour half-life temperature in the above-described range, a radical initiation reaction, that is, a crosslinking reaction may be effectively performed at a lamination process temperature for manufacturing an optoelectronic device.

Particularly, the organic peroxide crosslinking agent may include one or more selected from the group consisting of t-butylperoxy 2-ethylhexyl carbonate (TBEC), t-amylperoxy 2-ethylhexyl carbonate (TAEC), 1,1-di(t-butylperoxy)-3,3,5-trimethylcyclohexane, 1,1-di(t-butylperoxy)-cyclohexane, 2,2-di(t-amylperoxy)-butane, 2,2-di(t-butylperoxy)-butane, n-butyl-4,4-di(t-butylperoxy)valate, polyether poly(t-butyl peroxycarbonate), t-amylperoxy 3,5,5-trimethylhexanoate, t-butyl peroxyacetate and t-butyl peroxybenzoate, without limitation.

If the one-hour half-life temperature of the organic peroxide crosslinking agent is within the above-described range, the radical decomposition rate of the crosslinking agent is not faster than the crosslinking rate of the ethylene/alpha-olefin copolymer during a crosslinking process, and a desired degree of crosslinking may be achieved. In addition, the radical decomposition rate of the crosslinking agent is slow at common crosslinking conditions (140-150°C), and the slowdown of a crosslinking rate can be restrained.

The organic peroxide crosslinking agent may be included in 0.1 to 3.0 parts by weight, 0.1 to 2.0 parts by weight, or 0.5 to 1.5 parts by weight based on 100 parts by weight of the ethylene/alpha-olefin copolymer. If the organic peroxide crosslinking agent is included in the above-described range, the moldability of an encapsulant film is excellent, and a process constraint or the deterioration of the physical properties of the encapsulant may not occur, while sufficiently showing the improving effects of heat resistance.

### Crosslinking Auxiliary Agent

The composition for an encapsulant film of the present invention includes a crosslinking auxiliary agent, and here, the crosslinking auxiliary agent includes a compound represented by Formula 1. 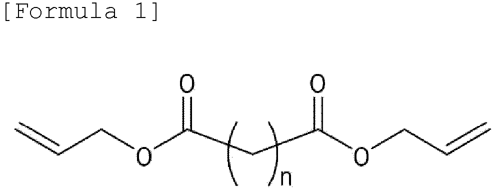 where n is an integer of 1 to 20.

Specifically, in Formula 1, n may be 3 or more, for example, an integer of 3 to 10, an integer of 3 to 8, an integer of 3 to 6, or an integer of 4 to 6.

Particularly, among materials having n of 2 or less, a material having biotoxicity may be included, and the present invention is characterized in not using the material as the crosslinking auxiliary agent. For example, diallyl maleate, diallyl fumarate, diallyl decarbonate, or the like are harmful to the point where it is marked by acute toxicity, oral/acute toxicity, percutaneous/skin corrosivity/skin irritation/severe eye damage/eye irritation/dermal hypersensitivity, or the like among harmfulness/dangerousness classification in SDS, and thus, these are inappropriate to use as the crosslinking auxiliary agents in the composition for an encapsulant film.

In addition, the compound represented by Formula 1 has a structure not including other substituent at an alkylene group chain connecting a functional group, and this is for controlling the polarity of the compound to increase the absorbency to a non-polar ethylene/alpha-olefin copolymer. As confirmed in the present invention, if the alkylene chain connecting a functional group includes other polar substituent, the compound represented by Formula 1 may not show improving effects on immersion time.

Particularly, the compound represented by Formula 1 may be a compound below.

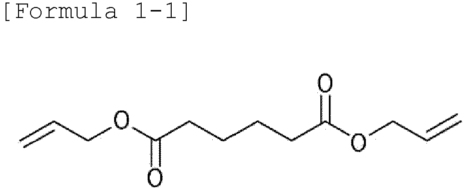

Different from the conventionally used crosslinking auxiliary agent like triallyl isocyanurate, the crosslinking auxiliary agent used in the present invention is non-polar and has excellent affinity with the ethylene/alpha-olefin to achieve rapid immersion.

In addition, if the crosslinking auxiliary agent is used in 0.01 to 3 parts by weight based on 100 parts by weight of the composition for an encapsulant film, the degree of crosslinking of at least 60%, which is commonly required in a solar cell encapsulant industry, may be achieved. In addition, the solar cell encapsulant using the crosslinking auxiliary agent may secure the volume resistance of at least 10¹⁶ Ω·cm and the light transmittance of at least 90%, which are the equal levels as those of the conventional solar cell encapsulant.

Like this, by including the crosslinking auxiliary agent in the composition for an encapsulant film, the absorption rate of the crosslinking agent and the crosslinking auxiliary agent in the composition for an encapsulant film may be markedly improved, and at the same time, the degree of crosslinking may be increased. Accordingly, the economic feasibility of production may be improved highly, while maintaining the heat resistance and the durability of a final product like an encapsulant film.

In the present invention, the composition for an encapsulant film may further include an allyl-containing compound as the crosslinking auxiliary agent.

The allyl-containing compound may include one or more selected from the group consisting of triallyl isocyanurate, triallyl cyanurate, diallyl phthalate, diallyl fumarate and diallyl maleate.

Here, the molar ratio of the compound represented by Formula 1 to the allyl-containing compound may be 1: 0.1 to 1: 10, particularly, 1: 0.2 to 1: 7, more particularly, 1: 0.3 to 1: 5, or 1: 0.3 to 1: 4.

Within the above-described range, the immersion time of the ethylene/alpha-olefin copolymer may be reduced, and the degree of crosslinking of the composition for an encapsulant film may be also increased.

In addition, the allyl-containing compound may be 0.01 to 3 parts by weight, particularly, 0.1 to 2.0 parts by weight, 0.1 to 1.50 parts by weight, or 0.1 to 1.00 parts by weight based on 100 parts by weight of the composition for an encapsulant film.

In the present invention, the crosslinking auxiliary agent may be 0.01 to 3 parts by weight, particularly, 0.1 to 2.0 parts by weight, or 0.20 to 1.50 parts by weight based on 100 parts by weight of the ethylene/alpha-olefin copolymer.

By including the crosslinking auxiliary agent in the above-described range, the degree of crosslinking of the composition for an encapsulant film may be maintained high, and the immersion time of the ethylene/alpha-olefin copolymer may be reduced.

### Silane Coupling Agent

The composition for an encapsulant film of the present invention may include a silane coupling agent, and this agent may play the role of improving the adhesiveness of an encapsulant film and a solar cell.

The silane coupling agent may use, for example, one or more selected from the group consisting of N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane, and γ-methacryloxypropyltrimethoxysilane (MEMO), without limitation.

The silane coupling agent may be included in 0.1 to 1.0 parts by weight, or 0.1 to 0.4 parts by weight based on 100 parts by weight of the ethylene/alpha-olefin copolymer. If the amount of the silane coupling agent is within the above-described range, adhesiveness with glass during manufacturing a solar cell may be excellent, and the deterioration of the long-term performance of a module due to water penetration may be prevented.

In addition, the composition for an encapsulant film of the present invention may additionally include one or more selected from the group consisting of an unsaturated silane compound, an amino silane compound, a light stabilizer, a UV absorbent and a thermal stabilizer.

The unsaturated silane compound may be grafted onto a main chain including the polymerization unit of the monomer of the copolymer of the present invention in the presence of a radical initiator, etc., and included in a polymerized type in a silane modified resin composition or an amino silane modified resin composition.

The unsaturated silane compound may be vinyltrimethoxy silane, vinyltriethoxy silane, vinyltripropoxy silane, vinyltriisopropoxy silane, vinyltributoxy silane, vinyltripentoxy silane, vinyltriphenoxy silane, or vinyltriacetoxy silane, and in an embodiment, vinyltrimethoxy silane or vinyltriethoxy silane may be used among them, without limitation.

In addition, the amino silane compound may act as a catalyst for promoting hydrolysis reaction for converting an unsaturated silane compound grafted onto the main chain of the copolymer, for example, a reactive functional group such as the alkoxy group of vinyltriethoxy silane into a hydroxyl group in the grafting modification step of the ethylene/alpha-olefin copolymer, to improve the adhesive strength of upper and lower glass substrates or with a back sheet composed of a fluorine resin, etc. At the same time, the amino silane compound may be directly involved as a reactant in copolymerization reaction and may provide an amino silane modified resin composition with a moiety having an amine functional group.

The amino silane compound is a silane compound including an amine group and is not specifically limited as long as it is a primary amine or a secondary amine. For example, the amino silane compound may use aminotrialkoxysilane, aminodialkoxysilane, etc., and examples may include one or more selected from the group consisting of 3-aminopropyltrimethoxysilane (APTMS), 3-aminopropyltriethoxysilane (APTES), bis[(3-triethoxysilyl)propyl]amine, bis[(3-trimethoxysilyl)propyl]amine, 3-aminopropylmethyldiethoxysilane, 3-aminopropylmethyldimethoxysilane, N-[3-(trimethoxysilyl)propyl]ethylenediamine (DAS), aminoethylaminopropyltriethoxysilane, aminoethylaminopropylmethyldimethoxysilane, aminoethylaminopropylmethyldiethoxysilane, aminoethylaminomethyltriethoxysilane, aminoethylaminomethylmethyldiethoxysilane, diethylenetriaminopropyltrimethoxysilane, diethylenetriaminopropyltriethoxysilane, diethylenetriaminopropylmethyldimethoxysilane, diethyleneaminomethylmethyldiethoxysilane, (N-phenylamino)methyltrimethoxysilane, (N-phenylamino)methyltriethoxysilane, (N-phenylamino)methylmethyldimethoxysilane, (N-phenylamino)methylmethyldiethoxysilane, 3-(N-phenylamino)propyltrimethoxysilane, 3-(N-phenylamino)propyltriethoxysilane, 3-(N-phenylamino)propylmethyldimethoxysilane, 3-(N-phenylamino)propylmethyldiethoxysilane, and N-(N-butyl)-3-aminopropyltrimethoxysilane. The amino silane compound may be used alone or as a mixture type.

The light stabilizer may capture the active species of the photothermal initiation of a resin to prevent photooxidation according to the use applied of the composition. The type of the light stabilizer used is not specifically limited, and for example, known compounds such as a hindered amine-based compound and a hindered piperidine-based compound may be used.

The UV absorbent absorbs ultraviolet rays from the sunlight, etc. and transforms into harmless thermal energy in a molecule according to the use of the composition, and may play the role of preventing the excitation of the active species of photothermal initiation in the resin composition. Particular types of the UV absorbent used are not specifically limited, and for example, one or a mixture of two or more of benzophenone-based, benzotriazole-based, acrylnitrile-based, metal complex-based, hindered amine-based, inorganic including ultrafine particulate titanium oxide and ultrafine particulate zinc oxide UV absorbents, etc. may be used.

In addition, the thermal stabilizer may include a phosphor-based thermal stabilizer such as tris(2,4-di-tert-butylphenyl)phosphite, phosphorous acid, bis[2,4-bis(1,1-dimethylethyl)-6-methylphenyl]ethylester, tetrakis(2,4-di-tert-butylphenyl) [1,1-biphenyl]-4,4'-diylbisphosphonate and bis(2,4-di-tert-butylphenyl)pentaerythritol diphosphite; and a lactone-based thermal stabilizer such as the reaction product of 8-hydroxy-5,7-di-tert-butyl-furan-2-on and o-xylene, and one or two or more of them may be used.

The amounts of the light stabilizer, UV absorbent, and thermal stabilizer are not specifically limited. That is, the amounts of the additives may be suitably selected considering the use of the resin composition, the shape or density of the additives, etc. Generally, the amounts may be suitably controlled in a range of 0.01 to 5 parts by weight based on 100 parts by weight of the total solid content of the composition for an encapsulant film.

### <Encapsulant Film>

In addition, the present invention provides an encapsulant film including the composition for an encapsulant film.

The encapsulant film of the present invention may be manufactured by molding the composition for an encapsulant film into a film or sheet shape. The molding method is not specifically limited, for example, a sheet or a film may be formed by a common process such as a T die process and extrusion. For example, the manufacture of the encapsulant film may be performed by an in situ process using an apparatus in which the preparation of a modified resin composition using the composition for an encapsulant film and a process for forming a film or a sheet are connected.

The thickness of the encapsulant film may be controlled to about 10 to 2,000 µm, or about 100 to 1,250 µm considering the supporting efficiency and breaking possibility of a device in an optoelectronic device, the reduction of the weight or workability of the device, and may be changed according to the particular use thereof.

### <Solar Cell Module>

In addition, the present invention provides a solar cell module including the encapsulant film. In the present invention, the solar cell module may have a configuration in which the gaps between the solar cells disposed in series or in parallel are filled with the encapsulant film of the present invention, a glass surface is disposed on a side where the sunlight strikes, and a backside is protected by a back sheet, but is not limited thereto. Various types and shapes of the solar cell modules manufactured by including the encapsulant film in this technical field may be applied in the present invention.

The glass surface may use tempered glass for protecting the solar cells from external impact and preventing breaking, and may use low iron tempered glass having the low iron content to prevent the reflection of the sunlight and to increase the transmittance of the sunlight, without limitation.

The back sheet is a climate-resistant film protecting the backside of the solar cell module from exterior, for example, a fluorine-based resin sheet, a metal plate or metal film such as aluminum, a cyclic olefin-based resin sheet, a polycarbonate-based resin sheet, a poly(meth)acryl-based resin sheet, a polyamide-based resin sheet, a polyester-based resin sheet, a laminated composite sheet of a climate-resistant film and a barrier film, etc., without limitation.

Besides, the solar cell module of the present invention may be manufactured by any methods well-known in this technical field only if including the encapsulant film, without limitation.

The solar cell module of the present invention is manufactured using an encapsulant film having excellent volume resistance, and the leakage of current outside through the movement of electrons in the solar cell module through the encapsulant film may be prevented. Accordingly, potential induced degradation (PID) phenomenon by which insulation is degraded, leakage current is generated, and the output of the module is rapidly degraded, may be largely restrained.

### Examples

Hereinafter, the present invention will be explained in more detail referring to embodiments. However, the embodiments are provided only for illustration, and the scope of the present invention is not limited thereto.

### Example 1

LF675 of LG Chem (ethylene/1-butene copolymer, density 0.877 g/cc, MI 14.0), was used as an ethylene alpha-olefin copolymer.

To the pellet resin of the ethylene/alpha-olefin copolymer, injected were t-butylperoxy 2-ethylhexyl carbonate (TBEC) as a crosslinking agent, 0.25 phr of diallyl adipate as a crosslinking auxiliary agent, and 3-(trimethoxysilyl)propyl methacrylate (MEMO) as a silane coupling agent, and immersion was performed.

An immersion process used a Haake mixer equipment. While stirring at a temperature of 41.5°C at 40 rpm, the change of a torque value in accordance with time was observed, and at a point where the torque value increased rapidly, the immersion was finished. Before being absorbed into the ethylene/alpha-olefin copolymer, the crosslinking agent plays the role of a lubricant to maintain a small torque value, and after being absorbed, the torque value of the crosslinking agent increases. Accordingly, the point where the torque value rapidly increased was set as an immersion completion time.

### Examples 2 to 5 and Comparative Examples 1 to 3

Encapsulant films were manufactured by the same method as Example 1 except for changing the type and amount of the crosslinking auxiliary agent as in Table 1.

**[Table 1]**

| | Crosslinking auxiliary agent |
|---|---|
| Example 1 | Diallyl adipate (0.25 phr) |
| Example 2 | Diallyl adipate (0.5 phr) |
| Example 3 | Diallyl adipate (1.0 phr) |
| Example 4 | Diallyl adipate (0.25 phr) + triallyl isocyanurate (0.25 phr) |
| Example 5 | Diallyl adipate (0.375 phr) + triallyl isocyanurate (0.125 phr) |
| Comparative Example 1 | triallyl isocyanurate (0.5 phr) |
| Comparative Example 2 | triallyl trimellitate (0.5 phr) |
| Comparative Example 3 | triallyl citrate (0.5 phr) |

| | |
|---|---|
| * Diallyl adipate 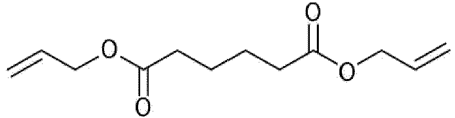 *Triallyl isocyanurate 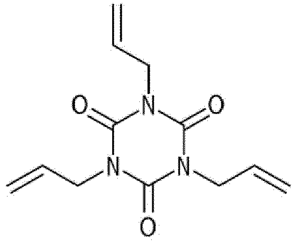 * Triallyl trimellitate 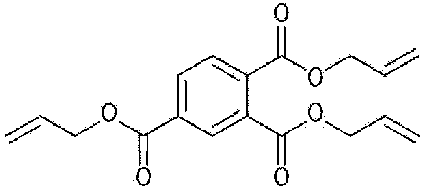 * Triallyl citrate 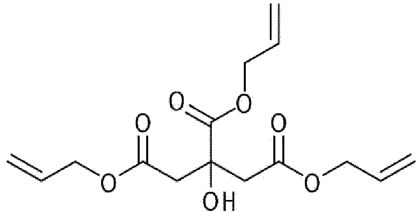 | |

*

### Experimental Example 1

### (1) Immersion Completion Time

As explained in Example 1, a point where a torque value rapidly increased was regarded as immersion completion time, and time from a point where stirring was initiated to a point where the immersion was completed, was measured and written in Table 2.

### (2) MDR Torque (MH-ML, Nm)

For the evaluation of the degree of crosslinking, the MDR torque value of each specimen was measured using a moving die rheometer (MDR) or Alpha Technologies Production.

Particularly, each of the encapsulant films having 550 µm manufactured in the Examples and Comparative Examples was cut by 1 g, four sheets were overlapped to prepare a sample of total 4 g, and measurement was conducted at 150°C for 20 minutes. Under the corresponding conditions, a M_{H} value and a M_{L} value were measured. MDR torque (M_{H}-M_{L}) was calculated by subtracting the measured M_{L} value from the measured M_{H} value. Here, M_{H} is the maximum vulcanizing torque, and M_{L} is the minimum vulcanizing torque.

### (3) Degree of Crosslinking (%)

The evaluation on the degree of crosslinking was conducted based on China Photovoltaic Industry Association (CPIA) standard and ASTM D2765. The encapsulant film manufactured above was cut into 10 cm x 10 cm, and vacuum lamination was conducted at 150°C for 20 minutes (vacuum for 5 minutes/pressurization for 1 minute/pressurization continued for 14 minutes) to obtain a crosslinked specimen.

The crosslinked specimen was cut into a size of 2 mm x 2 mm, and the specimens were weighed by 0.5 g and put in a 200 mesh wire net cage. Dissolution treatment was conducted under xylene reflux for 5 hours. After that, the specimen was dried in a vacuum oven, weights before and after the reflux were compared, and the degree of crosslinking of each specimen was measured.

**[Table 2]**

| | Immersion completion time (min) | T90 (min) | M_{H}-M_{L} (dNm) | Degree of crosslinking (%) |
|---|---|---|---|---|
| Example 1 | 18 | 13.4 | 2.5 | 65.0 |
| Example 2 | 30 | 13.6 | 2.9 | 73.3 |
| Example 3 | 38 | 13.8 | 3.1 | 74.6 |
| Example 4 | 47 | 12.85 | 3.37 | 75.3 |
| Example 5 | 42 | 13.05 | 3.11 | 73.0 |
| Comparative Example 1 | 60 | 12.9 | 3.9 | 77.2 |
| Comparative Example 2 | >60 | - | - | - |
| Comparative Example 3 | >60 | - | - | - |

As shown in Table 2, in the cases of Examples 1 to 5, using the compositions for an encapsulant film of the present invention, immersion rate was rapid, immersion completion time was reduced, and at the same time, the degree of crosslinking was also an excellent degree. Meanwhile, Comparative Example 1 using TAIC as the crosslinking auxiliary agent, and Comparative Examples 2 and 3, using a crosslinking auxiliary agent not corresponding to Formula 1 were confirmed to show slow immersion rate, thereby taking very long immersion completion time in contrast to the Examples.

Particularly, the immersion completion time in Comparative Examples 2 and 3 was rather increased when compared to Comparative Example 1. The crosslinking auxiliary agent used in Comparative Example 2 has a structure including three allyl groups and a benzene ring and has higher polarity than TAIC, and the crosslinking auxiliary agent used in Comparative Example 3 has a structure including three allyl groups and a hydroxyl group and has increased polarity, and so, affinity with the non-polar ethylene/alpha-olefin copolymer was reduced.

As described above, if the composition for an encapsulant film according to the present invention is used, a suitable level of the degree of crosslinking was shown, and effects of reducing immersion time were achieved.

### Experimental Example 2

Between two release films (thickness: about 100 µm), each of the encapsulant films (15 cm x 15 cm) manufactured in the Examples and Comparative Examples was put and crosslinked by laminating in a vacuum laminator at a process temperature of 150°C for a process time of 20 minutes.

### (1) Volume Resistance

Measurement was conducted based on ASTM D257 standard. Particularly, a sample was put in a Keithley 8009 test fixture under temperature conditions of 23 ± 1°C and humidity conditions of 50% ± 3, and measurement was conducted while applying a voltage of 1000 V for 600 seconds using Keithley 6517B electrometer connected.

### (2) Light Transmittance

In addition, light transmittance at 550 nm was measured using Shimadzu UV-3600 spectrophotometer (measurement mode: transmittance, wavelength interval: 1 nm, and measurement rate: medium) .

**[Table 3]**

| | Volume resistance (Ω ·cm) | Light transmittance (%) |
|---|---|---|
| Example 1 | 2.2 × 1016 | 91.5 |
| Example 2 | 2.7 × 1016 | 92.2 |
| Example 3 | 2.8 × 1016 | 92.6 |
| Example 4 | 2.4 × 1016 | 92.5 |
| Example 5 | 3.4 × 1016 | 92.3 |
| Comparative Example 1 | 2.7 × 1016 | 92.0 |
| Comparative Example 2 | - | - |
| Comparative Example 3 | - | - |

As shown in Table 3, it can be confirmed that if the composition for an encapsulant film according to the present invention is used, the volume resistance and light transmittance were also achieved to excellent levels.

## Claims

1. A composition for an encapsulant film, comprising an ethylene/alpha-olefin copolymer, an organic peroxide crosslinking agent, a crosslinking auxiliary agent and a silane coupling agent, wherein
the crosslinking auxiliary agent comprises a compound represented by the following Formula 1: 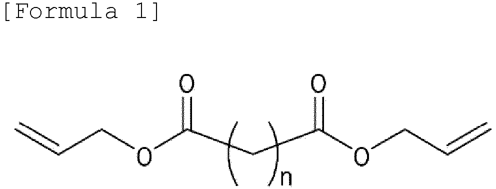
where n is an integer of 1 to 20.

2. The composition for an encapsulant film according to claim 1, wherein, in Formula 1, n is an integer of 3 to 10.

3. The composition for an encapsulant film according to claim 1, wherein the compound represented by Formula 1 is the following compound:

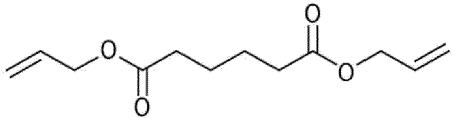

4. The composition for an encapsulant film according to claim 1, wherein the crosslinking auxiliary agent is 0.01 to 3 parts by weight based on 100 parts by weight of the composition for an encapsulant film.

5. The composition for an encapsulant film according to claim 1, wherein the crosslinking auxiliary agent further comprises an allyl-containing compound.

6. The composition for an encapsulant film according to claim 5, wherein the allyl-containing compound comprises one or more selected from the group consisting of triallyl isocyanurate, triallyl cyanurate, diallyl phthalate, diallyl fumarate and diallyl maleate.

7. The composition for an encapsulant film according to claim 5, wherein the allyl-containing compound is comprised in 0.01 to 3 parts by weight based on 100 parts by weight of the composition for an encapsulant film.

8. The composition for an encapsulant film according to claim 5, wherein a molar ratio of the compound represented by Formula 1 to the allyl-containing compound is 1: 0.1 to 1: 10.

9. The composition for an encapsulant film according to claim 1, wherein the organic peroxide crosslinking agent is one or more selected from the group consisting of t-butylperoxy 2-ethylhexyl carbonate, t-amylperoxy 2-ethylhexyl carbonate, 1,1-di(t-butylperoxy)-3,3,5-trimethylcyclohexane, 1,1-di(t-butylperoxy)-cyclohexane, 2,2-di(t-amylperoxy)-butane, 2,2-di(t-butylperoxy)-butane, n-butyl-4,4-di(t-butylperoxy)valate, polyether poly(t-butyl peroxycarbonate), t-amylperoxy 3,5,5-trimethylhexanoate, t-butyl peroxyacetate and t-butyl peroxybenzoate.

10. The composition for an encapsulant film according to claim 1, wherein an alpha-olefin comprises one or more selected from the group consisting of propylene, 1-butene, 1-pentene, 4-methyl-1-pentene, 1-hexene, 1-heptene, 1-octene, 1-decene, 1-undecene, 1-dodecene, 1-tetradecene, 1-hexadecene and 1-eicosene.

11. An encapsulant film comprising the composition for an encapsulant film according to any one of claims 1 to 10.

12. A solar cell module comprising the encapsulant film of claim 11.
